(19) Europäisches Patentamt / European Patent Office / Office européen des brevets

(11) **EP 1 858 023 A1**

(12) **EUROPÄISCHE PATENTANMELDUNG**

(43) Veröffentlichungstag:
**21.11.2007 Patentblatt 2007/47**

(51) Int Cl.:
**G11C 8/08** (2006.01)  **G11C 16/12** (2006.01)

(21) Anmeldenummer: **07009651.6**

(22) Anmeldetag: **15.05.2007**

(84) Benannte Vertragsstaaten:
**AT BE BG CH CY CZ DE DK EE ES FI FR GB GR HU IE IS IT LI LT LU LV MC MT NL PL PT RO SE SI SK TR**
Benannte Erstreckungsstaaten:
**AL BA HR MK YU**

(30) Priorität: **19.05.2006 DE 102006023934**

(71) Anmelder: **ATMEL Germany GmbH**
**74072 Heilbronn (DE)**

(72) Erfinder: **Sörensen, Arno**
**81549 München (DE)**

(74) Vertreter: **Müller, Wolf-Christian**
**Patentanwalt**
**Maaßstraße 32/1**
**69123 Heidelberg (DE)**

(54) **Speichervorrichtung mit einer nicht-flüchtigen Speichermatrix**

(57)    Speichervorrichtung
- mit einer nicht-flüchtigen Speichermatrix (EEPROM),
- mit mindestens einem Treiber ($60_1$, $60_n$, $61_1$, $61_m$) für eine Programmierung der Speichermatrix (EEPROM), der zum Treiben eines Programmierpotentials ($VP^+$, $VP^-$) mit der Speichermatrix (EEPROM) verbunden ist, und
- mit einem Ansteuerschaltkreis (31, 32) zur Ansteuerung des mindestens einen Treibers (60, $60_1$, $60_n$, $61_1$, $61_m$),

wobei
- der Ansteuerschaltkreis (31, 32) mindestens einen Schalter ($S_{11}$, $S_{12}$, $S_{21}$, $S_{22}$) zum Schalten eines Stromes ($I_{11}$, $I_{12}$, $I_{21}$, $I_{22}$) in Abhängigkeit von dem digitalen Logikpotential (Vdd, Vss) am Eingang (SIG IN) aufweist,
- der Ansteuerschaltkreis (31, 32) einen mit dem Ausgang (SIG_out_HVpos, SIG_out_HVneg) verbundenen Strom-Potential-Wandler ($[M_{N11}$, $M_{N12}$, $M_{P139}$ $M_{P14}$, $M_{P15}$, $M_{P16}$, $ST_1]$, $[M_{N21}$, $M_{N22}$, $M_{N23}$, $M_{N24}$, $M_{P21}$, $M_{P22}$, $ST_2])$ aufweist, der zur Abgabe eines von dem geschalteten Strom ($I_{11}$, $I_{12}$, $I_{21}$, $I_{22}$) abhängigen Steuerpotentials ($VS_1$, $VS_2$) zur Ansteuerung des mindestens einen Treibers (60, $60_1$, $60_n$, $61_1$, $61_m$) ausgebildet ist.

FIG.3a

**Beschreibung**

Die vorliegende Erfindung betrifft eine Speichervorrichtung mit einer nichtflüchtigen Speichermatrix, insbesondere ein elektrisch löschbares programmierbares Nur-Lese-Speicher- (EEPROM)-Matrixfeld oder ein elektrisch programmierbares Nur-Lese-Speicher (EPROM) - Matrixfeld.

Elektrisch löschbare programmierbare Nur-Lese-Speicher werden durch die englische Abkürzung EEPROM oder $E^2PROM$ abgekürzt. EEPROMs unter Anwendung der Programmierung durch Injektion heißer Ladungsträger anstelle der Programmierung durch Tunneln nach Fowler-Nordheim sind beispielsweise aus dem US-Patent Nr. 4,698,787 oder der DE 695 22 738 T2 bekannt.

Aus der US 7,023,738 B2 ist ein Schaltkreis zur Ansteuerung eine Zeile/Reihe von nicht-flüchtigen Speicherzellen bekannt. Potentialschieber werden verwendet um Logik-Ausgangswerte eines Dekodierers auf ein für die Programmierung der nicht-flüchtigen Speicherzellen operatives Signal mit einer positiven Programmierspannung und einer negativen Programmierspannung zu ändern.

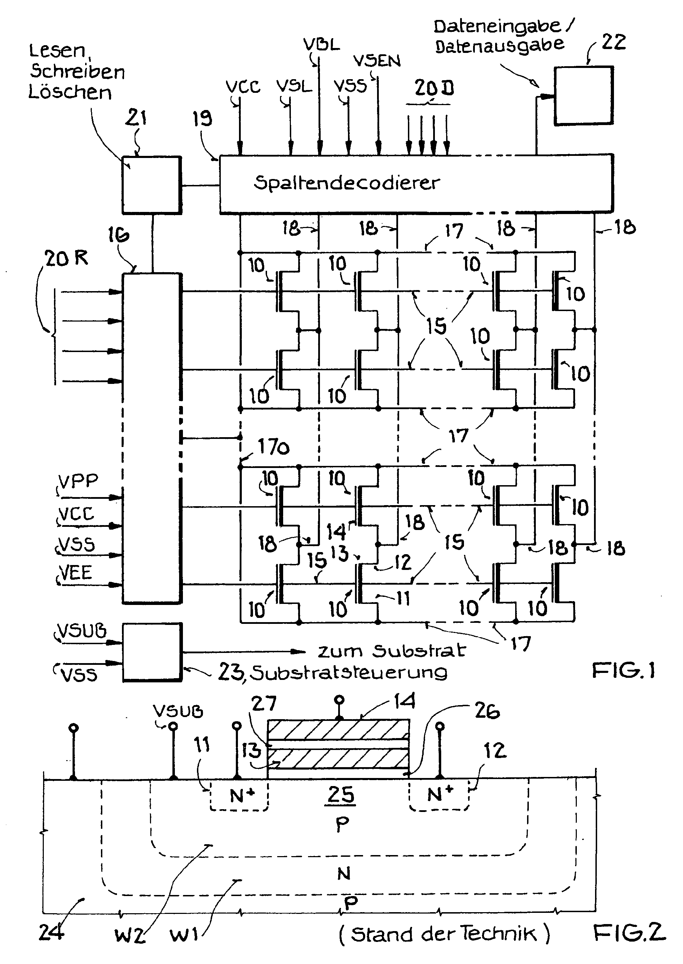

In einem Verfahren zum Programmieren von Speicherzellen wie in den Figuren 1 und 2 wird unter Anwendung von Heißkanaltechniken zur Programmierung einer Zelle durch Injektion heißer Ladungsträger eine hohe Spannung an das Steuer-Gate angelegt. Während des Programmierens einer ausgewählten Zelle durch Injektion heißer Ladungsträger sind die an Source, Drain und Steuer-Gate angelegten Spannungen: eine an die Source angelegte Referenzspannung, die gleich der Substratspannung (VSS, die 0 Volt sein kann) ist; eine an den Drain angelegte erste positive Spannung VBL, etwa +5 V bis +7 V in Bezug auf die Referenzspannung; und eine an das Steuer-Gate angelegte zweite positive Spannung VPP in Bezug auf die Referenzspannung.

Unter diesen Bedingungen ist der Kanal zwischen dem Drain und der Source gut leitend. Elektronen, die den Substrat-Drain-PN-Übergang erreichen, werden zwei elektrischen Feldern in der Matrix (EEPROM) unterworfen, wovon eines mit dem in Sperrrichtung vorgespannten Substrat-Drain-PN-Übergang zusammenhängt und das andere mit der positiven Spannung zwischen dem Steuer-Gate und dem schwebenden Gate zusammenhängt.

Das im Siliziumsubstrat in der Nähe des Substrat-Drain-PN-Übergangs und der Schnittstelle zum schwebenden Gate erzeugte elektrische Feld in der Matrix ist der Hauptfaktor beim Bestimmen der Programmierbarkeit durch Injektion heißer Ladungsträger in Speichern mit schwebendem Gate wie etwa EPROM- und Flash-EPROM-Matrixfeldern. Das elektrische Feld in der Matrix hängt primär von dem Drain-Source-Potential ab, umfasst jedoch auch andere Parameter wie etwa die Dotierungsprofile der Kanalzone und der Drain-Zone.

Ein Typ eines Speichermatrixfeldes mit schwebendem Gate erfordert sowohl eine 5 Volt-Spannungsversorgung als auch eine 12 Volt-Spannungsversorgung, als Versorgungspotentiale. In solchen zweifach versorgten Speichern wird die 12 Volt-Spannung verwendet, um die während der Programmierung benötigte +5 V- bis +7 V - Drain-Spannung VBL zu liefern. Ein anderer Typ eines Speichermatrixfeldes mit schwebendem Gate erfordert eine einzige 5 V - Versorgung. In jenem einfach versorgten Speicher wird die 5 Volt-Spannungsversorgung durch eine Ladungspumpenschaltung gepumpt, um während der Programmierung eine Drain-Spannung VBL zu liefern, die größer als +6 V ist.

Gemäß der DE 695 22 738 T2 kann eine Ladungspumpenschaltung verwendet werden, die die Source einer ausgewählten Zelle auf eine Spannung pumpt, die kleiner als die Spannung am Referenzanschluss der integrierten Speicherschaltung ist. Gleichzeitig wird das Drain-Potential der ausgewählten Zelle auf eine Spannung pumpt, die größer als die Spannung am Versorgungsspannungsanschluss des Speichers ist.

Beispielsweise wird in der DE 695 22 738 T2 aus einer 3 V-Versorgung durch Verwendung einer Ladungspumpenschaltung, die die Source-Spannung auf etwa 1,5 V unter der Spannung am Referenzanschluss dieser 3 V-Versorgung pumpt und gleichzeitig die Drain-Spannung auf 1,5 V über der Spannung am positiven Anschluss dieser 3 V-Versorgung pumpt, eine Drain-Source-Spannung von etwa 6 V erzielt. Die Ladungspumpenschaltung kann außerdem verwendet werden, um die Zellensubstratspannung auf einen Wert zu pumpen, der nahe bei der Source-Spannung liegt oder kleiner als diese ist. Zur Erhöhung der Wirksamkeit der Programmierung wird die Zellensubstratspannung auf einen Wert gepumpt, der kleiner als die Source-Spannung ist.

In Fig. 1 ist zur Veranschaulichung des Standes der Technik ein Matrixfeld (EEPROM) aus Speicherzellen gezeigt, die in einem Speicherbaustein integriert sind. Jede Zelle ist ein Transistor 10 mit einer Source 11, einem Drain 12, einem schwebenden Gate 13 und einem Steuer-Gate 14. Jedes Steuer-Gate 14 einer Zeile von Zellen 10 ist mit einer Wortleitung 15 verbunden, wobei jede Wortleitung 15 mit einem Wortleitungsdecodierer 16 verbunden ist.

Jede Source 11 in einer Zeile von Zellen 10 ist mit einer Source-Leitung 17 verbunden. Jeder Drain 12 in einer Spalte von Zellen 10 ist mit einer Drain-Spalte-Leitung 18 verbunden. Jede Source-Leitung 17 ist durch eine den Spalten gemeinsame Leitung 17a mit einem Spaltendecodierer 19 verbunden, und jede Drain-Spalte-Leitung 18 ist mit dem Spaltendecodierer 19 verbunden.

Im Lesemodus dient der Wortleitungsdecodierer 16 in Antwort auf Wortleitungs-Adresssignale über die Leitungen 20R und auf Signale von der Lese/Schreib/Lösch-Steuerschaltung 21 - die beispielsweise ein Mikroprozessor sein kann - dazu, ein vorgegebenes positives Potential VCC (etwa +5 V) an die ausgewählte Wortleitung 15 anzulegen und ein niedriges Potential (Masse oder VSS) an die nicht ausgewählten Wortleitungen 15 anzulegen.

Der Spaltendecodierer 19 dient zum Anlegen eines vorgegebenen positiven Potentials VSEN (etwa +1 V) an wenigstens die ausgewählte Drain-Spalte-Leitung 18 und zum Anlegen eines niedrigen Potentials (0 V) an die Source-Leitung 17. Der Spaltendecodierer 19 dient außerdem in Antwort auf Signale über die Adressleitungen 20D dazu, die ausgewählte Drain-Spalte-Leitung 18 der gewählten Zelle 10 mit dem Dateneingangs-/Datenausgangsanschluss 22 zu verbinden. Der leitende oder nicht-leitende Zustand der mit der ausgewählten Drain-Spalte-Leitung 18 und der ausgewählten Wortleitung 15 verbundenen Zelle 10 wird durch einen mit dem Dateneingangs/Datenausgangsanschluss 22 verbundenen (in Fig. 1 nicht gezeigten) Leseverstärker erfasst.

Im Flash-Löschmodus kann der Spaltendecodierer 19 dazu dienen, alle Drain-Spalte-Leitungen 18 schwebend zu steuern (mit einer hohen Impedanz wie etwa Matrixfeldeffekt-Transistoren, die in einen "AUS-Zustand vorgespannt sind, zu verbinden). Der Wortleitungsdecodierer 16 dient beispielsweise dazu, alle Wortleitungen 15 mit einem negativen Potential VEE (etwa - 10 V oder -13 V) zu verbinden. Der Spaltendecodierer 19 dient außerdem dazu, an alle Source-Leitungen 17 ein positives Potential VCC (etwa +5 V oder +3 V) anzulegen.

Die Substrat-Isolationswanne W2 von Fig. 2 der DE 695 22 738 T2 ist über eine Substrat-Steuerschaltung 23 mit VSS oder 0 V verbunden. Der Wortleitungsdecodierer 16 dient dazu, alle Wortleitungen 15 mit einem negativen Potential VEE (etwa -9 V) zu verbinden.

Der Spaltendecodierer 19 dient außerdem dazu, alle Source-Leitungen 17 und alle Drain-Leitungen 18 mit +6 V zu verbinden. Dabei ist die Substrat-Isolationswanne W2 ebenfalls mit +6 V verbunden. Diese Löschspannungen zwischen den Potentialen erzeugen eine ausreichende Feldstärke über die Gate-Oxid-Zone, um einen Fowler-Nordheim-Tunnelstrom zu erzeugen, der Ladung vom schwebenden Gate 13 überträgt, wodurch die Speicherzelle 10 gelöscht wird. Da das Potential auf der Wortleitung 15 negativ ist, bleibt die Zelle 10 während des Löschens im nicht-leitenden Zustand.

Im Schreib- oder Programmiermodus der DE 695 22 738 T2 kann der Wortleitungsdecodierer 16 in Antwort auf Wortleitungs-Adresssignale über die Leitungen 20R und auf Signale von der Lese/Schreib-Lösch-Steuerschaltung 21 dazu dienen, ein vorgegebenes erstes Programmier-potential VVP (etwa +12 V) an eine ausgewählte Wortleitung 15 einschließlich eines ausgewählten Steuer-Gates 14 anzulegen. Der Spaltendecodierer 19 dient außerdem dazu, ein zweites Programmier-potential VBL (etwa +5 V bis +10 V) an eine ausgewählte Drain-Spalte-Leitung 18 und somit an den Drain 12 der ausgewählten Zelle 10 anzulegen.

Bei der Schaltung der Figuren 1 und 2 dieses Standes der Technik sind die Source-Leitungen 17 beispielsweise mit dem Referenzpotential VSS, das Masse sein kann, verbunden. Sämtliche nicht ausgewählten Drain-Spalte-Leitungen 18 sind mit dem Referenzpotential VSS verbunden oder potentialfrei gemacht. Die Programmierspannungen aufgrund dieser Potentialdifferenzen erzeugen einen hohen (Drain- 12- Source- 11-) Stromzustand im Kanal der ausgewählten Speicherzelle 10, was dazu führt, dass in der Nähe des Drain-Kanal-Übergangs Heißkanalelektronen und Lawinendurchbruchelektronen erzeugt werden, die durch das Kanaloxid in das schwebende Gate 13 der ausgewählten Zelle 10 injiziert werden.

Die Programmierzeit wird so gewählt, dass sie ausreichend lang ist, um das schwebende Gate 13 mit einer negativen Programmierladung von etwa -2 V bis -6 V in Bezug auf die Kanalzone (bei 0 V am Steuer-Gate 14) zu programmieren. Deshalb erzeugt das Programmierpotential VPP des Standes der Technik von beispielsweise 12 V an einer ausgewählten Wortleitung 15 einschließlich des ausgewählten Steuer-Gates 14 ein Potential von etwa +7,2 V am ausgewählten schwebenden Gate 13.

Die Spannung zwischen dem schwebenden Gate 13 (bei etwa +7,2 V) und der geerdeten (etwa 0 V) Source-Leitung 17 reicht nicht aus, um einen Fowler-Nordheim-Tunnelstrom über das Gate-Oxid zwischen einer Source 11 und einem schwebenden Gate 13 zur Ladung des schwebenden Gates 13 einer ausgewählten oder nicht ausgewählten Zelle 10 hervorzurufen. Das schwebende Gate 13 der ausgewählten Zelle 10 wird mit Heißelektronen geladen, die während der Programmierung injiziert werden, wobei die Elektronen ihrerseits den Source-Drain-Pfad unter dem schwebenden Gate 13 der ausgewählten Zelle 10 bei +5 V an ihrem Steuer-Gate 14 nicht-leitend machen, einem Zustand, der als "Null-Bit" gelesen wird. Nichtprogrammierte Zellen 10 weisen Source-Drain-Pfade unter dem schwebenden Gate 13 auf, die bei +5 V an ihren Steuer-Gates 14 leitend sind, wobei diese Zellen 10 als "Eins-Bits" gelesen werden.

Beim Schreib- oder Programmiervorgang gemäß des Standes der Technik der Figuren 1 und 2 wird das zur Programmierung erforderliche Drain-Source-Potential durch Verwendung einer Ladungspumpenschaltung, die die Source 11 der ausgewählten Zelle 10 auf ein Potential VSL von etwa -1 V bis -2 V unter dem Potential VSS am negativen Anschluss der Versorgung (von vielleicht 3 V) pumpt und gleichzeitig den Drain 12 der ausgewählten Zelle 10 auf ein Potential VBL von etwa +6 V über dem Potential an der Source pumpt, erzielt.

Gleichzeitig wird ein Substrat-Potential VSUB einer Substrat-Isolierwanne W2 im Substrat 24 über eine Substrat-Steuerschaltung 23 entweder mit dem Potential VSUB, das das gleiche Potential VSL wie das der Source 11 sein kann, oder mit einem negativeren Potentialwert von etwa -2 V bis -3 V unter dem Potential VSS am negativen Anschluss der Leistungsversorgung verbunden. Die Substrat-Isolierwanne W2 muss wenigstens jede ausgewählte Zelle 10 oder das gesamte Speicherzellenmatrixfeld isolieren.

Die Programmierung der ausgewählten Zelle 10 durch Heißladungsträgerinjektion wird erzielt, indem ein Impuls von VPP von etwa +10 V an das Gate 14 der ausgewählten Zelle 10 angelegt wird. Die nicht ausgewählten Wortleitungen sind mit VSS oder 0 V verbunden oder mit einem Potential von etwa -1 V bis -2 V in Bezug auf VSS verbunden, um einen Leckverlust über nicht ausgewählte Zellen zu verhindern.

Der Erfindung liegt die Aufgabe zu Grunde, eine Speichervorrichtung mit einer möglichst vereinfachten Herstellung weiter zu entwickeln. Diese Aufgabe wird durch eine Speichervorrichtung mit den Merkmalen des Anspruchs 1 gelöst. Vorteilhafte Weiterbildungen der Erfindung sind Gegenstand von Unteransprüchen.

Demzufolge ist eine Speichervorrichtung mit einer nicht-flüchtigen Speichermatrix vorgesehen. Diese nicht-flüchtige Speichermatrix ist vorzugsweise eine elektrisch löschbare programmierbare Nur-Lese-Speicher- (engl. abgekürzt: EEPROM)-Matrix oder eine elektrisch programmierbare Nur-Lese-Speicher (engl. abgekürzt: EPROM) - Matrix.

Die nicht-flüchtige Speichermatrix verliert dabei nicht die gespeicherten Daten, wenn eine Versorgungsspannung abgeklemmt wird.

Die Speichervorrichtung weist vorzugsweise mindestens einen Treiber für eine Programmierung der Speichermatrix auf. Der Treiber dient zum Treiben eines Programmierpotentials und ist hierzu mit der Speichermatrix verbunden. Der Treiber ist dabei für die zur Programmierung notwendigen Ströme und Spannungen ausgelegt, so dass beispielsweise bezüglich des Programmierpotentials spannungsfeste und/oder stromfeste Transistoren für den Treiber verwendet werden. Die Programmierung kann je nach verwendetem Speicherzellenaufbau ein positives Programmierpotential oder ein negatives Programmierpotential erfordern. Vorteilhafterweise verwendet die Speichervorrichtung sowohl ein positives als auch ein negatives Programmierpotential, um deren Differenz für eine Programmierung an die Zelle der nicht-flüchtigen Speichermatrix anzulegen.

Zur Ansteuerung des mindestens einen Treibers ist ein Ansteuerschaltkreis vorgesehen. Der Ansteuerschaltkreis steuert den Treiber vorzugsweise in Abhängigkeit von einem Bitwert, also einer logischen Null oder einer logischen Eins am Eingang. Der Bitwert ist dabei vorteilhafterweise eines von zwei digitalen Logikpotentialen, beispielsweise von + 5 Volt oder Masse-potential. Der Ansteuerschaltkreis ist dabei ausgebildet diese Binäre Information an seinem Eingang in ein Steuerpotential zu wandeln.

Hierzu weist der Ansteuerschaltkreis vorzugsweise mindestens einen Schalter zum Schalten eines Stromes in Abhängigkeit von dem digitalen Logikpotential am Eingang auf. Der geschaltete Stromfluss beinhaltet dabei vorzugsweise die Information über den Bitwert am Eingang. Beispielsweise ist es möglich dem Stromfluss den Wert logisch Eins und dem Wert logisch Null den "Nicht-Stromfluss" zuzuordnen. Bevorzugt ist vorgesehen, dass dem Wert logisch Eins ein erster Stromfluss und dem Wert logisch Null ein zweiter Stromfluss zugeordnet ist. In diesem Fall sind ein Schalter für den ersten Stromfluss und eine Schalter für den zweiten Stromfluss vorgesehen, die vorteilhafterweise miteinander über einen Inverter verbunden sind. Als Schalter kann beispielsweise ein Schalttransistor, vorteilhafterweise ein NMOS-Feldeffekttransistor oder ein PMOS-Feldeffekttransistor verwendet werden.

Der Ansteuerschaltkreis weist bevorzugt einen mit einem Ausgang verbundenen Strom-Potential-Wandler auf. Dieser Strom-Potential-Wandler ist zur Abgabe eines von dem geschalteten Strom abhängigen Steuerpotentials zur Ansteuerung des mindestens einen Treibers ausgebildet. Der Strom-Potential-Wandler wandelt die im geschalteten Strom enthaltene binäre Information in das Steuerpotential um, wobei vorzugsweise das Steuerpotential zur Ansteuerung des Treibers zwischen zwei Potentialwerten in Abhängigkeit von der binären Information geschaltet wird. Das Steuerpotential wird dabei bevorzugt zwischen Potentialwerten geschaltet, die beide höher als das positive Logikpotential oder beide niedriger als das Logikpotential Masse sind.

Gemäß einer bevorzugten Weiterbildung weist der Strom-Potential-Wandler einen Stromsummationsknoten auf, wobei das Steuerpotential vom Potential im Stromsummationsknoten abhängig ist. Die Summe der Ströme aus und in den Stromsummationsknoten ist null. In einer vorteilhaften Ausgestaltung der Erfindung weist der Strom-Potential-Wandler einen Schwellwertschalter auf, dessen Eingang mit dem Stromsummationsknoten und dessen Ausgang mit dem Ausgang des Ansteuerschaltkreises verbunden ist. Ein derartiger Schwellwertschalter ist beispielsweise ein Schmitt-Trigger, der ein definiertes digitales Ausgangssignal liefert.

In einer vorteilhaften Ausgestaltung der Erfindung ist vorgesehen, dass der Strom-Potential-Wandler eine Anzahl von Stromspiegeln zur Spiegelung des geschalteten Stromes auf den Stromsummationsknoten aufweist. Vorteilhafterweise fließt dabei der geschaltete Strom zumindest durch einen Stromspiegel, der den geschalteten Strom auf den Stromsummationsknoten spiegelt. Wird lediglich ein einziger Strom geschalten ist die benötigte Anzahl der Stromspiegel eins. Werden jedoch zumindest zwei geschaltete Ströme verwendet, wird vorteilhafterweise eine Mehrzahl von Stromspiegeln benötigt, wobei vorzugsweise die zwei geschalteten Ströme in den Stromsummationsknoten gespiegelt werden.

Gemäß einer vorteilhaften Ausgestaltung der Erfindung ist vorgesehen, dass der mindestens eine Treiber eine Push-Pull-Stufe aufweist. Die Push-Pull-Stufe weist dabei zumindest zwei komplementäre Transistoren auf, wobei ein Transistor der komplementären Transistoren mit einer Programmierspannung versorgt ist. Werden sowohl eine positive Programmierspannung als auch eine negative Programmierspannung zur Programmierung der nicht-flüchtigen Speichermatrix verwendet, ist ein erster Transistor der komplementären Transistoren an einem ersten Anschluss der positiven Programmierspannung angeschlossen und ein zweiter Transistor der komplementären Transistoren an einem zweiten Anschluss der negativen Programmierspannung angeschlossen. Die Push-Pull-Stufe weist dabei vorzugsweise zumindest einen PMOS-Transistor und zumindest einen NMOS-Transistor auf, wobei sowohl der PMOS-Transistor als auch der NMOS-Transistor eine Drain-Source-Durchbruchsspannung für die verwendeten Programmierpotentiale aufweist. Vorteilhafterweise sind der Source-Anschluss des PMOS-Transistors mit einem ersten positiven Programmierpotential und der der Source-Anschluss des NMOS-Transistors mit einem zweiten negativen Programmierpotential verbunden.

Gemäß einer bevorzugten Weiterbildung der Erfindung ist zwischen dem Ansteuerschaltkreis und dem mindestens einen Treiber ein Decodierer geschaltet. Dieser Decodierer ist vorteilhafterweise als Multiplexer ausgebildet. Der Decodierer ermöglicht das Decodieren der am Eingang des Ansteuerschaltkreises anliegenden Informationen (Bitwerte) bezüglich der Zeilen und Spalten der flüchtigen Speichermatrix und schaltet den jeweiligen anliegenden Bit-Wert an den durch die Decodierung zugeordneten Treiber der Zeile oder Spalte der flüchtigen Speichermatrix durch. Auch ist es prinzipiell möglich den Ansteuerschaltkreis zwischen den Decodierer und den Treiber zu schalten. In diesem alternativen Fall würden in dem Ansteuerschaltkreis die bereits decodierten Werte für die Zeilen und Spalten der flüchtigen Speichermatrix zur Programmierung in jeweils ein Steuerpotential gewandelt werden.

Gemäß einer besonders vorteilhaften Ausgestaltung der Erfindung ist der Strom-Potential-Wandler mittels eines ersten Versorgungsspannungsanschlusses mit einem ersten Programmierpotential und mittels eines zweiten Versorgungsspannungsanschlusses mit einem zweiten Programmierpotential verbunden. Der erste Versorgungsspannungsanschluss und der zweite Versorgungsspannungsanschluss sind dabei vorzugsweise unabhängig von Versorgungsspannungsanschlüssen für die Logikpotentiale. Bevorzugt entspricht dabei eine Differenzspannung zwischen dem ersten Programmierpotential und dem zweiten Programmierpotential einer Logikspannung zwischen einem ersten Logikpotential und einem zweiten Logikpotential. Auch ist es ausreichend, dass die Differenzspannung nach Art einer derartigen Logikspannung eingestellt ist, dieser also im Wesentlichen entspricht oder dieser angenähert ist.

Vorteilhafterweise weist die Speichervorrichtung eine veränderbare Spannungsquelle auf. Bevorzugt sind dabei der erste Versorgungsspannungsanschluss und/oder der zweite Versorgungsspannungsanschluss mit der veränderbaren Spannungsquelle verbunden. Vorteilhafterweise weist die veränderbare Spannungsquelle einen Spannungsregler oder eine steuerbare Ladungspumpe auf, die beispielsweise mit dem Treiber und dem Ansteuerschaltkreis auf einem Halbleiterchip integriert sein kann. Die veränderbare Spannungsquelle kann veränderbare Spannungen oder Potentiale abgeben. Zur Veränderung können die Spannungen oder Potentiale der veränderbaren Spannungsquelle beispielsweise stetig steuerbar sein oder beispielsweise geschalten werden. Die veränderbare Spannungsquelle ist mit dem Ansteuerschaltkreis zur Anpassung des Steuerpotentials für die Programmierung der nicht-flüchtigen Speichermatrix verbunden.

Bevorzugt ist vorgesehen, dass die veränderbare Spannungsquelle mit einer Anzahl von Versorgungsanschlüssen des Decodierers verbunden ist. Der Decodierer ist dabei vorteilhafterweise für auftretende Programmierspannungen ausgelegt und weist hierzu entsprechend spannungsfeste Transistoren auf.

Bevorzugt ist ein Mittel zur Begrenzung der Stromentnahme aus dem ersten und/oder zweiten Versorgungsspannungsanschluss vorgesehen. Vorteilhafterweise ist dieses Mittel ein Teil des Ansteuerschaltkreises, der Strom aus der Spannungsquelle entnimmt. Vorteilhafterweise weist das Mittel zur Begrenzung der Stromentnahme zumindest eine Konstantstromquelle auf, die den geschalteten Strom abgibt.

Der Ansteuerschaltkreis ist vorteilhafterweise sowohl mit den Versorgungsspannungsanschlüssen für die Programmierpotentiale als auch mit den Versorgungsspannungsanschlüssen für die Logikpotentiale verbunden. Gemäß einer vorteilhaften Ausgestaltung weist der Ansteuerschaltkreis derartige Verbindungen auf, dass der geschaltete Strom zwischen einem Logikpotential (Vdd oder Masse) und einem Programmierpotential fließt.

In einer bevorzugten Weiterbildung der Erfindung ist vorgesehen, dass ein erster Ansteuerschaltkreis und ein zum ersten Ansteuerschaltkreis vorzugsweise komplementärer zweiter Ansteuerschaltkreis zur Abgabe eines ersten positiven Steuerpotentials durch den ersten Ansteuerschaltkreis und zur Abgabe eines zweiten negativen Steuerpotentials durch den zweiten Ansteuerschaltkreis ausgebildet sind. Dabei sind der erste Ansteuerschaltkreis mit einem PMOS-Transistor des Treibers zum Treiben eines positiven Programmierpotentials und der zweite Ansteuerschaltkreis mit einem NMOS-Transistor des Treibers zum Treiben eines negativen Programmierpotentials verbunden.

Gemäß einer vorteilhaften Weiterbildung ist die Speichervorrichtung derart ausgebildet und eingerichtet, dass die Speichermatrix zum Programmieren sowohl mit dem positiven Programmierpotential als auch mit dem negativen Programmierpotential betrieben ist, wobei das positive Programmierpotential positiver als jedes Logikpotential und das negative Programmierpotential negativer als jedes Logikpotential ist.

Weiterhin liegt der Erfindung die Aufgabe zu Grunde eine Verwendung anzugeben. Diese Aufgabe wird durch die Verwendung mit den Merkmalen des Anspruchs 15 gelöst. Vorteilhafte Weiterbildungen sind aus den Merkmalen beschriebener Speichervorrichtungen abzuleiten.

Demzufolge ist eine Verwendung eines Ansteuerschaltkreises zur Ansteuerung mindestens eines Treibers zum Treiben eines Programmierpotentials für eine Programmierung einer nicht-flüchtigen Speichermatrix vorgesehen. Mindestens ein Schalter des Ansteuerschaltkreises schaltet einen Strom in Abhängigkeit von einem digitalen Logikpotential am Eingang. Ein Strom-Potential-Wandler des Ansteuerschaltkreises gibt ein von dem geschalteten Strom abhängiges Steuerpotential zur Ansteuerung des mindestens einen Treibers ab.

Anstelle der Angabe von Potentialen können auch Spannungen definiert werden, die sich auf ein festes Bezugspotential, beispielsweise ein Masse-Potential beziehen.

Die zuvor beschriebenen Weiterbildungsvarianten sind sowohl einzeln als auch in Kombination besonders vorteilhaft. Dabei können sämtliche Weiterbildungsvarianten untereinander kombiniert werden. Einige mögliche Kombinationen sind in der Beschreibung des Ausführungsbeispiels der Figuren erläutert. Diese dort dargestellten Möglichkeiten von Kombinationen der Weiterbildungsvarianten sind jedoch nicht abschließend.

Im Folgenden wird die Erfindung in Ausführungsbeispielen anhand von Zeichnungen näher erläutert.

Dabei zeigen

Fig. 1     ein Blockschaltbild für ein Speichermatrixfeld nach dem Stand der Technik,

Fig. 2     einen Querschnitt einer Speicherzelle mit schwebendem Gate nach dem Stand der Technik,

Fig. 3a     eine erste Ausführungsform eines Ansteuerschaltkreises,

Fig. 3b     eine zweite Ausführungsform eines Ansteuerschaltkreises, und

Fig. 4     ein Blockschaltbild für ein Speichermatrixfeld mit Ansteuerelektronik.

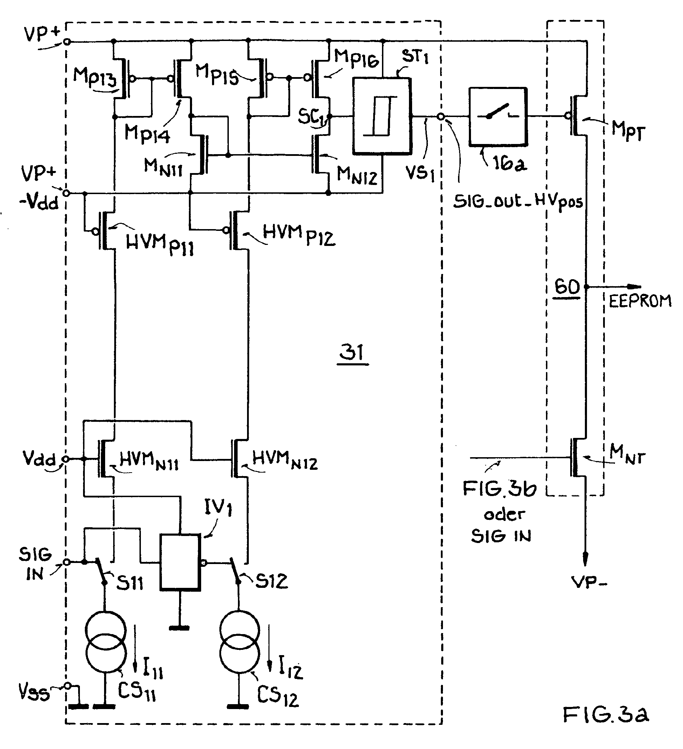

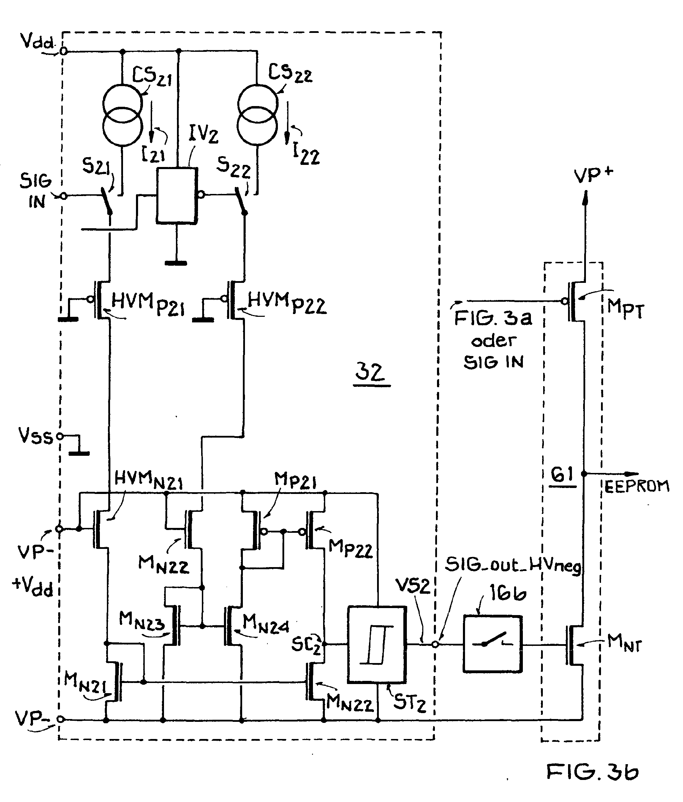

Eine Funktion eines Ansteuerschaltkreises 31 - wie dieser in Fig. 3a dargestellt ist - ist es, das an einem Eingang SIG IN anliegende Logiksignal (logisch 1 = Vdd oder logisch null = Vss) an einem Hochvolt-Ausgang SIG_out_HVpos auszugeben. Dabei bewirkt das Eingangssignal logisch 1 = Vdd am Eingang das Ausgangssignal $VP^+$-Vdd, während das Eingangssignal logisch null = Vss das Ausgangssignal $VP^+$ bewirkt.

Der Ansteuerschaltkreis 31 der Fig. 3a weist zwei Teilschaltkreise auf, wobei der erste Teilschaltkreis mit den Logikpotential Vdd (logisch eins) und Masse (Vss; logisch null) zur Ausbildung der Logikspannung Vdd versorgt wird. Der zweite Teilschaltkreis wird hingegen durch die Programmierpotentiale $VP^+$ und $VP^+$-Vdd versorgt. Dabei ist

$$VP^+ - (VP^+\text{-Vdd}) = Vdd$$

Demzufolge ist die Potentialdifferenz zwischen den Programmierpotentialen $VP^+$ und $VP^+$-Vdd der Logikspannung Vdd zumindest angenähert oder entspricht dieser sogar, so dass in beiden Teilschaltkreisen des Ansteuerschaltkreises 31 die Logiktransistoren $M_{N11}$, $M_{N12}$ sowie $M_{P13}$ bis $M_{P16}$ der gleichen Technologie verwendet werden können.

Die Programmierpotentiale $VP^+$ und $VP^+$-Vdd sind dabei wesentlich höher als die Logikpotentiale Vdd und Masse (Vss). Beispielsweise ist Masse 0 Volt, Vdd = 3,3 Volt, $VP^+$ = 12 Volt und $VP^+$-Vdd = 8,7 Volt. Die Durchbruchspannung der Logiktransistoren $M_{N11}$, $M_{N12}$ sowie $M_{P13}$ bis $M_{P16}$ ist dabei für die Logikspannung Vdd von 3,3 Volt ausgelegt. Die Programmierpotentiale $VP^+$ und $VP^+$-Vdd werden beide benötigt, um einen PMOS-Transistor $M_{PT}$ als positiven Zweig einer Push-Pull-Stufe 60 anzusteuern. Der Sourceanschluss des PMOS-Transistors $M_{PT}$ ist ebenfalls mit dem Programmierpotential $VP^+$ verbunden und schaltet dieses zur Programmierung auf Speicherzellen einer nichtflüchtigen Speichermatrix EEPROM durch.

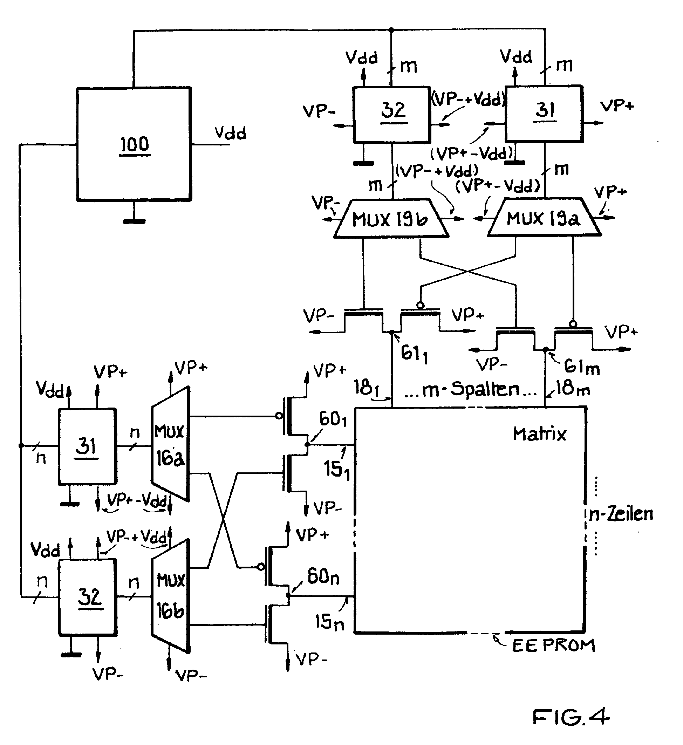

Hierzu weist der Ansteuerschaltkreis den Hochvoltausgang SIG_out_HVpos zur Ansteuerung des Treibertransistors $M_{PT}$ der Push-Pull-Stufe 60 zur Programmierung der nicht-flüchtigen Matrix EEPROM eines elektrisch löschbaren programmierbaren Nur-Lese-Speichers oder eines elektrisch programmierbaren Nur-Lese-Speicher auf. Zwischen dem Ansteuerschaltkreis 31 und der Push-Pull-Stufe 60 kann bevorzugt ein Decodierer 16a geschaltet sein, wie dies zu Fig. 4 näher erläutert wird. Dieser Decodierer 16a kann alternativ auch vor dem Ansteuerschaltkreis 31 geschalten sein. In diesem Fall müsste jedoch für jeden Ausgang des Decodierers 16a ein Ansteuerschaltkreis vorgesehen sein, so dass evtl. mehr Chipfläche benötigt würde.

Der Ansteuerschaltkreis 31 weist demzufolge vier Versorgungsanschlüsse für die Potentiale Masse (Vss), Vdd, $VP^+$ und $VP^+$-Vdd und einen Signaleingang SIG IN zusätzlich zu dem Hochvolt Signalausgang SIG_out_HVpos auf, der über den Decodierer 16a mit dem PMOS-Transistor $M_{PT}$ der Push-Pull-Stufe 60 verbunden ist.

Der Ansteuerschaltkreis 31 weist zwei Schalter $S_{11}$ und $S_{12}$ auf, wobei der Schalter $S_{11}$ mit dem Signaleingang SIG IN des Ansteuerschaltkreises 31 direkt verbunden ist. Hingegen ist der Schalter $S_{12}$ über einen Inverter $IV_1$ mit dem Signaleingang SIG IN verbunden. Demzufolge schalten die Schalter logisch disjunkt. Als Schalter können beispielsweise PMOS- oder NMOS-Transistoren verwendet werden. Weiterhin weist der Ansteuerschaltkreis 31 zwei Stromquellen $CS_{11}$ und $CS_{12}$ auf, die mit den Schaltern $S_{11}$ und $S_{12}$ derart verbunden sind, dass der Strom $I_{11}$ oder $I_{12}$ der jeweiligen Stromquelle $CS_{11}$ beziehungsweise $CS_{12}$ durch die Schalter $S_{11}$ beziehungsweise $S_{12}$ in Abhängigkeit von einem digitalen Logikpotential am Eingang SIG IN geschalten wird. Das digitale Logikpotential ist dabei ein Binärwert, also logisch Eins, was dem Potential Vdd entspricht oder logisch Null, was dem Potential Masse (Vss) entspricht. Die Stromquellen $CS_{11}$ und $CS_{12}$ bewirken vorteilhaft, dass der Strom $I_{11}$ oder $I_{12}$ aus Versorgungsanschlüssen für die Programmierpotentiale $VP^+$ und $VP^+$-Vdd begrenzt ist.

Weiterhin weist der Ansteuerschaltkreis 31 einen mit einem Ausgang SIG_out_HVpos verbundenen Strom-Potential-Wandler auf, der im Ausführungsbeispiel der Fig. 3a aus den Stromspiegeln $M_{N11}$, $M_{N12}$, dem Stromspiegel $M_{P13}$, $M_{P14}$, dem Stromspiegel $M_{P15}$, $M_{P16}$ und dem Schmitt-Trigger $ST_1$ besteht. Der Strom-Potential-Wandler ist zur Abgabe eines von dem geschalteten Strom $I_{11}$, $I_{12}$ abhängigen Steuerpotentials $VS_1$ zur Ansteuerung des Treibers 60 ausgebildet. Hierzu spiegeln die Stromspiegel $M_{P13}$, $M_{P14}$ und $M_{N11}$, $M_{N12}$ den geschalteten Strom $I_{11}$ der Stromquelle $CS_{11}$ als negativen Wert auf einen Stromsummationsknoten $SC_1$. Der Stromspiegel $M_{P15}$, $M_{P16}$ spiegelt den geschalteten Strom $I_{12}$ der Stromquelle $CS_{12}$ als positiven Wert auf den Stromsummationsknoten $SC_1$.

Da die Ströme $I_{11}$ und $I_{12}$ durch den Inverter $IV_1$ niemals gleichzeitig eingeschalten werden, wird im Stromsummationsknoten $SC_1$ die Ladung verschoben, so wird in dem Stromsummationsknoten lediglich eine Kapazität umgeladen und es fließt durch den Stromsummationsknoten kein signifikanter Querstrom. Am Eingang des mit dem Stromsummationsknoten $SC_1$ verbundenen Schmitt-Triggers liegt daher das obere Programmierpotential $VP^+$ oder das untere Programmierpotential $VP^+$-Vdd in Abhängigkeit von dem digitalen Potential am Eingang SIG IN des Ansteuerschaltkreises 31 an. Unabhängig von der Flankensteilheit der Signale stellt der Schmitt-Trigger $ST_1$ sicher, dass am Ausgang SIG_out_HVpos in digitales Signal ausgegeben wird.

Die Transistoren $M_{N11}$, $M_{N12}$, $M_{P13}$, $M_{P14}$, $M_{P15}$, $M_{P16}$ der Stromspiegel, der Schmitt-Trigger $ST_1$, die Schalter $S_{11}$ und $S_{12}$ als auch die Stromquellen $CS_{11}$ und $CS_{12}$ sind hinsichtlich ihrer Durchbruchsspannung lediglich für Logikpotentialunterschiede ausgelegt, die kleiner sind als ein Potentialunterschied zum Programmierpotential $VP^+$. Um diese Schaltkreisteile vor Zerstörung zu schützen, sind die Hochvolt-NMOS-Feldeffekttransistoren $HVM_{N11}$ und $HVM_{N12}$ vorgesehen, deren Gateanschluss jeweils mit dem Logikpotential Vdd verbunden ist, so dass an deren Sourceanschluss jeweils nur ein um die Thresholdspannung kleineres Potential als das Logikpotential Vdd anliegen kann.

Diese Hochvolt-NMOS-Feldeffekttransistoren $HVM_{N11}$ und $HVM_{N12}$ sind weiterhin dafür ausgelegt, dass über deren Drain-Source-Strecke die Spannungsdifferenz zwischen dem Programmierpotential $VP^+$ und einem Logikpotential (Vdd oder Masse) abfallen kann, ohne dass deren Drain-Source-Strecke durchbricht. Die gleiche Funktion erfüllten die Hochvolt-PMOS-Feldeffekttransistoren $HVM_{P11}$ und $HVM_{P12}$, die entgegen dem Ausführungsbeispiel der Fig. 3a auch fortgelassen werden können, sofern der Spannungsabfall über die Hochvolt-NMOS-Feldeffekttransistoren $HVM_{N11}$ und $HVM_{N12}$ ausreicht. Da über dem Gate-Oxid der Hochvolt-NMOS-Feldeffekttransistoren $HVM_{N11}$ und $HVM_{N12}$ oder der Hochvolt-PMOS-Feldeffekttransistoren $HVM_{P11}$ und $HVM_{P12}$ lediglich eine Spannung abfällt, die kleiner oder gleich der Logikspannung ist, ist es nicht erforderlich die Hochvolt-Transistoren mit einem dickeren Gate-Oxid auszubilden.

Entspricht ein Ausgangspotential $VS_1$ am Ausgang SIG_out_HVpos dabei $VP^+$, liegt dieser Potentialwert an einem Gate des Treibertransistors $M_{PT}$ der Push-Pull-Stufe 60 an. Da auch dessen Sourceanschluss an diesem Potentialwert $VP^+$ angeschlossen ist, sperrt dieser Transistor $M_{PT}$. Entspricht das Ausgangspotential $VS_1$ hingegen $VP^+$-Vdd, so ist die Spannung am Gateanschluss des Transistors $M_{PT}$ um den Betrag Vdd niedriger, so dass der Transistor $M_{PT}$ durchschaltet und dieser das Potential $VP^+$ auf eine Zelle des nicht-flüchtigen Speichermatrix EEPROM schaltet.

In Fig. 3a nicht dargestellt, jedoch weiterhin bevorzugt vorgesehen ist, dass eine veränderbare Spannungsquelle mit einem ersten Versorgungsspannungsanschluss des Ansteuerschaltkreises 31 zum Anlegen des ersten, veränderlichen Programmierpotentials $VP^+$ und mit einem zweiten Versorgungsspannungsanschluss des Ansteuerschaltkreises 31 zum Anlegen eines zweiten, veränderlichen Programmierpotentials $VP^+$-Vdd verbunden ist. Vorteilhafterweise ist die veränderbare Spannungsquelle derart ausgebildet ist, dass das zweite, veränderliche Programmierpotential $VP^+$-Vdd um eine feste Differenzspannung Vdd von dem ersten, veränderlichen Programmierpotential $VP^+$ verschieden ist. Dies bewirkt vorteilhafterweise, dass die Versorgungsspannung Vdd des Ansteuerschaltkreises 31 als feste Differenz der beiden Programmierpotentiale $VP^+$ und $VP^+$-Vdd unabhängig von einer absoluten Veränderung der beiden Programmierpotentiale $VP^+$ und $VP^+$-Vdd über die Zeit im Wesentlichen konstant bleibt. Vorteilhafterweise ist die Differenzspannung Vdd nach Art einer auf dem Halbleiterchip vorgesehenen Logikspannung, so dass die Transistoren $M_{N11}$, $M_{N12}$, $M_{P13}$, $M_{P14}$, $M_{P15}$, $M_{P16}$ der Stromspiegel des Ansteuerschaltkreises 31 aus derselben Technologie entsprechend der Logik verwendet werden können.

In Fig. 3a ist von dem Ansteuerschaltkreis 31 mittels des Steuerpotentials $VS_1$, das die Potentiale $VP^+$ oder $VP^+$-Vdd annehmen kann, der Highside-Transistor $M_{PT}$ der Push-Pull-Stufe 60 angesteuert. Ist das zweite (negative) Programmierpotential das Masse-Potential, kann ein Low-Side-Transistor $M_{NT}$ der Push-Pull-Stufe 60 durch die Logikpotentiale Vdd und Masse (Vss) direkt angesteuert werden (in Fig. 3a durch SIG IN angedeutet). Ist das zweite Programmier-Potential nicht Masse Vss, sondern wird zur Programmierung ein zweites negativeres Programmierpotential $VP^-$ benötigt, wird der Ansteuerschaltkreis um einen negativen komplementären Zweig 32 ergänzt. Dieser negative komplementäre Zweig 32 ist in Fig. 3b als Blockschaltbild dargestellt. Auch dieser weist Stromspiegel $M_{N21}$, $M_{N22}$, $M_{N23}$, $M_{N24}$, $M_{P21}$, $M_{P22}$, einen Schmitt-Trigger $ST_2$, Schalter $S_{21}$ und $S_{22}$, Stromquellen $CS_{21}$ und $CS_{22}$, einen Inverter $IV_2$

und Hochvolt-NMOS-Feldeffekttransistoren $HVM_{N21}$, $HVM_{N22}$ und Hochvolt-PMOS-Feldeffekttransistoren $HVM_{P21}$ und $HVM_{P22}$ auf.

Die Funktionsweise des Ansteuerschaltkreises 32 der Fig. 3b ist analog zu der des Ansteuerschaltkreises 31 der Fig. 3a, mit dem Unterschied, dass am Hochvolt-Ausgang SIG_out_HVneg. ein negatives Steuerpotential abgegeben wird, das über einen Decodierer 16b auf einen Hochvolt-NMOS-Feldeffekttransistor $M_{NT}$ des Treibers 60 geleitet wird und diesen Hochvolt-NMOS-Feldeffekttransistor $M_{NT}$ öffnet oder sperrt, so dass an die zugeordneten Anschlüsse der nichtflüchtigen Speicherzellen der Matrix EEPROM mit dem negativen Programmierpotential VP- verbindbar sind.

Fig. 4 zeigt ein Blockschaltbild einer Speichervorrichtung. Die Logik 100, beispielsweise ein Controller, ist über einen n-Bit breiten Parallelbus mit einer Anzahl von n Ansteuerschaltkreisen 31 und einer Anzahl n Ansteuerschaltkreisen 32 verbunden. Alle Ausgänge der Ansteuerschaltkreise 31 und 32 werden über jeweils einen n-Bit breiten Parallelbus mit Decodierern 16a und 16b verbunden die über Push-Pull-Stufen $60_1$ bis $60_n$ die n-Zeilen der Matrix EEPROM ansteuern. Ein entsprechender Aufbau ist für die m-Spalten über die Decodierer 19a und 19b vorgesehen. Besonders vorteilhaft ist hierbei, dass die Decodierer 16a, 16b beziehungsweise 19a, 19b dem Signalspeicher 31, 32 nachgeschaltet und den Push-Pull-Stufen $60_1$ bis $60_n$ und $60_1$ bis $60_m$ vorgeschaltet sind. Hierdurch kann Chipfläche eingespart werden.

Die Decodierer (MUX) 16a und 19a sind mit Versorgungsspannungsanschlüssen mit den Programmierpotentialen VP+ und VP+-Vdd verbunden, um die High-Side-Transistoren der PushPull-Stufen $60_1$ bis $60_n$ und $61_1$ bis $61_m$ anzusteuern. Die Decodierer (MUX) 16b und 19b sind mit Versorgungsspannungsanschlüssen mit den Programmierpotentialen VP- und VP-+Vdd verbunden, um die Low-Side-Transistoren der PushPull-Stufen $60_1$ bis $60_n$ und $61_1$ bis $61_m$ anzusteuern. Mit denselben Versorgungsspannungsanschlüssen sind auch die Ansteuerschaltkreises 31 und 32 verbunden.

Die Ausbildung der Ansteuerschaltkreise 31, 32 gemäß den Ausführungsbeispielen der Figuren 3a und 3b weist den Vorteil auf, das lediglich ein Typ eines NMOS-Transistors und eines PMOS-Transistors benötigt wird, da über deren Gate-Oxid nicht eine von den Programmierpotentialen V+ oder V- abhängige Programmierspannung abfällt.

Transistoren mit zusätzlich hierzu notwendigem dickem Gate-Oxid werden nicht benötigt.

Bezugszeichenliste

| | |
|---|---|
| 10 | Speicherzelle |
| 11 | Source, Quelle |
| 12 | Drain, Senke |
| 13 | schwebendes Gate, schwebendes Tor |
| 14 | Steuer-Gate, Steuer-Tor |
| 15 | Wortleitung |
| 16 | Wortleitungsdecodierer |
| 16a | Wortleitungsdecodierer/Zeilendecodierer zur Ansteuerung von PMOS |
| 16b | Wortleitungsdecodierer/Zeilendecodierer zur Ansteuerung von NMOS |
| 17 | Source-Leitung |
| 17a | gemeinsame Leitung |
| 18 | Drain-Spalte-Leitung |
| 19 | Spaltendecodierer |
| 19a | Spaltendecodierer zur Ansteuerung von PMOS |
| 19b | Spaltendecodierer zur Ansteuerung von NMOS |
| 20R | Leitungen |
| 20D | Adressleitungen |
| 21 | Lese/Schreib/Lösch-Steuerschaltung |
| 22 | Dateneingangs-/Datenausgangsanschluss |
| 23 | Substrat-Steuerschaltung |
| 24 | Halbleitersubstrat |
| 25 | Kanal |
| 26 | Gate-Isolation |
| 27 | Zwischenschichtisolator |
| 31, 32 | Ansteuerschaltkreis |
| 60, $60_1$, $60_n$, $61_1$, $61_m$ | Treiber, Push-Pull-Stufe |
| 100 | Logik, Controller |
| EEPROM | Speichermatrix |
| $M_{N11}$, $M_{N12}$, $M_{N21}$, $M_{N22}$, | NMOS-Transistor |

EP 1 858 023 A1

| | |
|---|---|
| $M_{N23}$, $M_{N24}$ | |
| $M_{NT}$, $HVM_{N11}$, $HVM_{N12}$, $HVM_{N21}$, $HVM_{N22}$ | Hochvolt-NMOS-Transistor |
| $M_{PT3}$ $M_{P13}$, $M_{P14}$, $M_{P15}$, $M_{P16}$, $M_{P21}$, $M_{P22}$ | PMOS-Transistor |
| $HVM_{P21}$, $HVM_{P22}$, $HVM_{P11}$, $HVM_{P12}$ | Hochvolt-PMOS-Transistor |
| $IV_1$, $IV_2$ | Inverter |
| $ST_1$, $ST_2$ | Schmitt-Trigger |
| S11, S12, S21, S22 | Schalter |
| $CS_{11}$, $CS_{12}$, $CS_{21}$, $CS_{22}$ | Stromquelle, Stromsenke |
| W1 | tiefe Wanne |
| W2 | Substrat-Isolierwanne |
| Vdd | positives Logikpotential |
| Vss | Masse |
| VSL | negatives Potential an der Source |
| VBL | positives Potential am Drain |
| VPP | positives Potential am Steuer-Gate |
| VEE | negatives Potential im Löschmodus |
| VSEN | vorgegebenes positives Potential |
| VSUB | Substratpotential |
| $VP^+$, $VP^+$-Vdd | positives Programmierpotential |
| $VP^-$, $VP^-$+Vdd | negatives Programmierpotential |
| n | Zeilenbusbreite |
| m | Spaltenbusbreite |

**Patentansprüche**

1.  Speichervorrichtung

    - mit einer nicht-flüchtigen Speichermatrix (EEPROM),
    - mit mindestens einem Treiber ($60_1$, $60_n$, $61_1$, $61_m$) für eine Programmierung der Speichermatrix (EEPROM), der zum Treiben eines Programmierpotentials ($VP^+$, $VP^-$) mit der Speichermatrix (EEPROM) verbunden ist, und
    - mit einem Ansteuerschaltkreis (31, 32) zur Ansteuerung des mindestens einen Treibers (60, $60_1$, $60_n$, $61_1$, $61_m$),

    wobei

    - der Ansteuerschaltkreis (31, 32) mindestens einen Schalter ($S_{11}$, $S_{12}$, $S_{21}$, $S_{22}$) zum Schalten eines Stromes ($I_{11}$, $I_{12}$, $I_{21}$, $I_{22}$) in Abhängigkeit von einem digitalen Logikpotential (Vdd, Vss) am Eingang (SIG IN) aufweist,
    - der Ansteuerschaltkreis (31, 32) einen mit einem Ausgang (SIG_out_HVpos, SIG_out_HVneg) verbundenen Strom-Potential-Wandler ([$M_{N11}$, $M_{N12}$, $M_{P13}$, $M_{P14}$, $M_{P15}$, $M_{P16}$, $ST_1$], [$M_{N21}$, $M_{N22}$, $M_{N23}$, $M_{N24}$, $M_{P21}$, $M_{P22}$, $ST_2$]) aufweist, der zur Abgabe eines von dem geschalteten Strom ($I_{11}$, $I_{12}$, $I_{21}$, $I_{22}$) abhängigen Steuerpotentials ($VS_1$, $VS_2$) zur Ansteuerung des mindestens einen Treibers (60, $60_1$, $60_n$, $61_1$, $61_m$) ausgebildet ist.

2.  Speichervorrichtung nach Anspruch 1, bei der der Strom-Potential-Wandler ([$M_{N11}$, $M_{N12}$, $M_{P13}$, $M_{P14}$, $M_{P15}$, $M_{P16}$, $ST_1$], [$M_{N21}$, $M_{N22}$, $M_{N23}$, $M_{N24}$, $M_{P21}$, $M_{P22}$, $ST_2$]) einen Stromsummationsknoten ($SC_1$, $SC_2$) aufweist, wobei das Steuerpotential ($VS_1$, $VS_2$) vom Potential im Stromsummationsknoten ($SC_1$, $SC_2$) abhängig ist.

3.  Speichervorrichtung nach Anspruch 2, bei der der Strom-Potential-Wandler ([$M_{N11}$, $M_{N12}$, $M_{P13}$, $M_{P14}$, $M_{P15}$, $M_{P16}$, $ST_1$], [$M_{N21}$, $M_{N22}$, $M_{N23}$, $M_{N24}$, $M_{P21}$, $M_{P22}$, $ST_2$]) einen Schwellwertschalter ($ST_1$, $ST_2$) aufweist, der mit dem Stromsummationsknoten ($SC_1$, $SC_2$) und mit dem Ausgang (SIG_out_HVpos, SIG_out_HVneg) des Ansteuerschaltkreises (31, 32) verbunden ist.

4.  Speichervorrichtung nach einem der Ansprüche 2 oder 3, bei der der Strom-Potential-Wandler ([$M_{N11}$, $M_{N12}$, $M_{P13}$, $M_{P14}$, $M_{P15}$, $M_{P16}$, $ST_1$], [$M_{N21}$, $M_{N22}$, $M_{N23}$, $M_{N24}$, $M_{P21}$, $M_{P22}$, $ST_2$]) eine Anzahl von Stromspiegeln ([$M_{N11}$, $M_{N12}$, $M_{P13}$, $M_{P14}$, $M_{P15}$, $M_{P16}$], [$M_{N21}$, $M_{N22}$, $M_{N23}$, $M_{N24}$, $M_{P21}$, $Mp_{22}$]) zur Spiegelung des geschalteten Stromes ($I_{11}$, $I_{12}$, $I_{21}$, $I_{22}$) auf den Stromsummationsknoten ($SC_1$, $SC_2$) aufweist.

5. Speichervorrichtung nach einem der vorhergehenden Ansprüche, bei der der mindestens eine Treiber ($60$, $60_1$, $60_n$, $61_1$, $61_m$) eine Push-Pull-Stufe aufweist.

6. Speichervorrichtung nach einem der vorhergehenden Ansprüche, bei der zwischen dem Ansteuerschaltkreis ($31$, $32$) und dem mindestens einen Treiber ($60$, $60_1$, $60_n$, $61_1$, $61_m$) ein Decodierer ($16a$, $16b$, $19a$, $19b$) geschaltet ist.

7. Speichervorrichtung nach einem der vorhergehenden Ansprüche, bei der der Strom-Potential-Wandler ($[M_{N11}$, $M_{N12}$, $M_{P13}$, $M_{P14}$, $M_{P15}$, $M_{P16}$, $ST_1]$, $[M_{N21}$, $M_{N22}$, $M_{N23}$, $M_{N24}$, $M_{P21}$, $M_{P22}$, $ST_2]$) mittels eines ersten Versorgungsspannungsanschlusses mit einem ersten Programmierpotential ($VP^+$, $VP^-+Vdd$) und mittels eines zweiten Versorgungsspannungsanschlusses mit einem zweiten Programmierpotential ($VP^+-Vdd$, $VP^-$) verbunden ist.

8. Speichervorrichtung nach Anspruch 7, bei der eine Differenzspannung zwischen dem ersten Programmierpotential ($VP^+$, $VP^-+Vdd$) und dem zweiten Programmierpotential ($VP^+-Vdd$, $VP^-$) einer Logikspannung zwischen einem ersten Logikpotential ($Vdd$) und einem zweiten Logikpotential (Masse, Vss) entspricht oder nach Art einer derartigen Logikspannung ist.

9. Speichervorrichtung nach einem der Ansprüche 7 oder 8, bei der der erste Versorgungsspannungsanschluss und/oder der zweite Versorgungsspannungsanschluss mit einer veränderbaren Spannungsquelle verbunden sind.

10. Speichervorrichtung nach Anspruch 9, bei der die veränderbare Spannungsquelle einen Spannungsregler oder eine steuerbare Ladungspumpe aufweist.

11. Speichervorrichtung nach einem der Ansprüche 7 bis 10, mit einem Mittel ($CS_{11}$, $CS_{12}$, $CS_{21}$, $CS_{22}$) zur Begrenzung der Stromentnahme aus dem ersten und/oder zweiten Versorgungsspannungsanschluss.

12. Speichervorrichtung nach Anspruch 11, bei der das Mittel zur Begrenzung der Stromentnahme zumindest eine Konstantstromquelle ($CS_{11}$, $CS_{12}$, $CS_{21}$, $CS_{22}$) aufweist, die den geschalteten Strom ($I_{11}$, $I_{12}$, $I_{21}$, $I_{22}$) abgibt.

13. Speichervorrichtung nach einem der vorhergehenden Ansprüche, bei der der Ansteuerschaltkreis ($31$, $32$) derartige Verbindungen aufweist, dass der geschaltete Strom ($I_{11}$, $I_{12}$, $I_{21}$, $I_{22}$) zwischen einem Logikpotential ($Vdd$, (Masse) $Vss$) und einem Programmierpotential ($VP^+$, $VP^-+Vdd$, $VP^+-Vdd$, $VP^-$) fließt.

14. Speichervorrichtung nach einem der vorhergehenden Ansprüche, bei der ein erster Ansteuerschaltkreis ($31$) und ein zum ersten Ansteuerschaltkreis ($31$) vorzugsweise komplementärer zweiter Ansteuerschaltkreis ($32$) zur Abgabe eines ersten positiven Steuerpotentials ($VS_1$) durch den ersten Ansteuerschaltkreis ($31$) und zur Abgabe eines zweiten negativen Steuerpotentials ($VS_2$) durch den zweiten Ansteuerschaltkreis ($32$) ausgebildet sind, wobei der erste Ansteuerschaltkreis ($31$) mit einem PMOS-Transistor ($M_{PT}$) des Treibers ($60$, $60_1$, $60_n$, $61_1$, $61_m$) zum Treiben eines positiven Programmierpotentials ($VP^+$) und der zweite Ansteuerschaltkreis ($32$) mit einem NMOS-Transistor ($M_{NT}$) des Treibers ($60$, $60_1$, $60_n$, $61_1$, $61_m$) zum Treiben eines negativen Programmierpotentials ($VP^-$) verbunden sind. 15.Verwendung eines Ansteuerschaltkreises ($31$, $32$) zur Ansteuerung mindestens eines Treibers ($60$, $60_1$, $60_n$, $61_1$, $61_m$) zum Treiben eines Programmierpotentials ($VP^+$, $VP^-$) für eine Programmierung einer nichtflüchtigen Speichermatrix (EEPROM), wobei

- mindestens ein Schalter ($S_{11}$, $S_{12}$, $S_{21}$, $S_{22}$) des Ansteuerschaltkreises ($31$, $32$) einen Strom ($I_{11}$, $I_{12}$, $I_{21}$, $I_{22}$) in Abhängigkeit von einem digitalen Logikpotential ($Vdd$, $Vss$) am Eingang (SIG IN) schaltet,
- ein Strom-Potential-Wandler ($[M_{N11}$, $M_{N12}$, $M_{P13}$, $M_{P14}$, $M_{P15}$, $M_{P16}$, $ST_1]$, $[M_{N21}$, $M_{N22}$, $M_{N23}$, $M_{N24}$, $M_{P21}$, $M_{P22}$, $ST_2]$) des Ansteuerschaltkreises ($31$, $32$) ein von dem geschalteten Strom ($I_{11}$, $I_{12}$, $I_{21}$, $I_{22}$) abhängiges Steuerpotential ($VS_1$, $VS_2$) zur Ansteuerung des mindestens einen Treibers ($60$, $60_1$, $60_n$, $61_1$, $61_m$) abgibt.

FIG.1

( Stand der Technik )  FIG.2

FIG.3a

FIG. 3b

FIG.4

**Europäisches Patentamt**

# EUROPÄISCHER RECHERCHENBERICHT

Nummer der Anmeldung

EP 07 00 9651

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2004/062085 A1 (WANG YONGLIANG [US] ET AL) 1. April 2004 (2004-04-01)<br>* Zusammenfassung *<br>* Absätze [0038] - [0043] *<br>* Abbildung 3a *<br>----- | 1-14 | INV.<br>G11C8/08<br>G11C16/12 |
| P,X | WO 2006/075202 A (TOKYO SHIBAURA ELECTRIC CO [JP]; TAKEUCHI KEN [JP]; FUTATSUYAMA TAKUYA) 20. Juli 2006 (2006-07-20)<br>* Zusammenfassung *<br>* Abbildungen 1,7 *<br>* Seiten 12,20,25 *<br>----- | 1-14 | |
| A | EP 0 426 417 A2 (OKI ELECTRIC IND CO LTD [JP]) 8. Mai 1991 (1991-05-08)<br>* Zusammenfassung *<br>* Abbildung 1b *<br>* das ganze Dokument *<br>----- | 1-14 | |
| | | | RECHERCHIERTE SACHGEBIETE (IPC)<br><br>G11C |

Der vorliegende Recherchenbericht wurde für alle Patentansprüche erstellt

| Recherchenort | Abschlußdatum der Recherche | Prüfer |
|---|---|---|
| München | 28. August 2007 | Operti, Antonio |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

 

& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 07 00 9651

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

28-08-2007

| Im Recherchenbericht angeführtes Patentdokument | Datum der Veröffentlichung | Mitglied(er) der Patentfamilie | Datum der Veröffentlichung |
|---|---|---|---|
| US 2004062085 A1 | 01-04-2004 | AU 2003275369 A1<br>WO 2004032143 A2 | 23-04-2004<br>15-04-2004 |
| WO 2006075202 A | 20-07-2006 | CN 1930634 A<br>JP 2006196078 A<br>KR 20060124755 A<br>US 2007036016 A1 | 14-03-2007<br>27-07-2006<br>05-12-2006<br>15-02-2007 |
| EP 0426417 A2 | 08-05-1991 | DE 69024332 D1<br>DE 69024332 T2<br>JP 2790495 B2<br>JP 3147596 A<br>US 5117392 A | 01-02-1996<br>14-08-1996<br>27-08-1998<br>24-06-1991<br>26-05-1992 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4698787 A
- DE 69522738 T2
- US 7023738 B2